# EUROPÄISCHE PATENTSCHRIFT

(11) **EP 1 550 358 B1**
(45) Veröffentlichungstag und Bekanntmachung des Hinweises auf die Patenterteilung: **14.04.2010**
(21) Anmeldenummer: 03788912.8
(22) Anmeldetag: 19.09.2003
(51) Int. Cl.: H05K 3/46, H05K 3/00

(54) **LEITERPLATTE MIT MINDESTENS EINEM STARREN UND MINDESTENS EINEM FLEXIBLEN BEREICH SOWIE VERFAHREN ZUR HERSTELLUNG VON STARR-FLEXIBLEN LEITERPLATTEN**
PRINTED BOARD COMPRISING AT LEAST ONE STIFF AREA AND AT LEAST ONE FLEXIBLE AREA, AND METHOD FOR THE PRODUCTION OF STIFF-FLEXIBLE PRINTED BOARDS
CARTE DE CIRCUIT IMPRIME PRESENTANT AU MOINS UNE PARTIE RIGIDE ET UNE PARTIE SOUPLE ET PROCEDE DE PRODUCTION DE CARTES DE CIRCUITS IMPRIMES RIGIDES ET SOUPLES

(30) Priorität: 19.09.2002 DE 10243637
(43) Veröffentlichungstag der Anmeldung: 06.07.2005
(73) Patentinhaber: Ruwel AG, 35083 Wetter/Hessen (DE)
(72) Erfinder: MÜNZBERG, Roland, 35274 Kirchhain (DE)
(74) Vertreter: Gesthuysen, Michael
(86) Internationale Anmeldenummer: PCT/EP2003/010438
(87) Internationale Veröffentlichungsnummer: WO 2004/032583

(56) Entgegenhaltungen:
- DE-A- 3 302 857
- DE-C- 4 003 344
- DE-C- 4 003 345
- DE-C- 4 206 746
- DE-C- 4 208 610
- US-A- 4 687 695
- US-A- 5 095 628
- US-A- 5 144 742
- YOSHIDA H ET AL: "DEVELOPMENT OF LCD MODULES FOR AUTOMOBILES" SID INTERNATIONAL SYMPOSIUM DIGEST OF APPLICATIONS PAPERS. SAN JOSE, JUNE 14 - 16, 1994, SANTA ANA, SID, US, Bd. 25, 14. Juni 1994 (1994-06-14), Seiten 27-30, XP000492842 ISSN: 0097-0966

## Beschreibung

Die Erfindung betrifft eine Leiterplatte mit mindestens einem starren und mindestens einem flexiblen Bereich gemäß dem Oberbegriff des Patentanspruchs 1. Daneben betrifft die Erfindung noch eine Multilayer-Leiterplatte bestehend mindestens einer solchen Leiterplatte, und noch ein Verfahren zur Herstellung einer solchen starr-flexiblen Leiterplatte.

Schon seit vielen Jahrzehnten werden gedruckte elektrische Schaltungen beispielsweise in elektrischen Geräten und in Kraftfahrzeugen zur elektronischen Regelung und Steuerung eingesetzt. Es handelt sich hierbei üblicherweise um starre Leiterplatten, die einerseits diskrete Bauelemente und hochintegrierte Bausteine elektrisch miteinander verbinden und andererseits als Träger derselben fungieren. Die Leiterplatten bestehen zumeist aus einer oder mehreren Einzellagen von glasfaserverstärkten, ausgehärteten Epoxidharzplatten, die zur Ausbildung von Leiterbahnen bzw. Leiterbildern ein- oder beidseitig kupferkaschiert sind. Bei mehrlagigen Leiterplatten sind die einzelnen Ebenen bzw. die auf den Einzellagen angeordneten Leiterbahnen durch metallisierte Bohrungen in der Leiterplatte miteinander elektrisch verbunden.

Seit ca. 30 Jahre werden neben rein starren Leiterplatten auch gedruckte Schaltungen eingesetzt, die nebeneinander starre und flexible Bereiche aufweisen; sogenannte starr-flexible Leiterplatten. Durch das Vorsehen von flexiblen Bereichen kann eine größere Anzahl von starren Leiterplatten in nahezu jeder gewünschten räumlichen Anordnung ohne Steckerleisten oder Verdrahtungen mechanisch und elektrisch miteinander verbunden werden. Darüber hinaus bieten die flexiblen Bereiche die Möglichkeit, mehrere starre Leiterplattenbereiche so "übereinander zu falten", daß eine große Leiterplattenfläche und damit auch eine Vielzahl von auf den Leiterplatten angeordneten diskreten Bauelemente auf einem relativ kleinen Raum untergebracht werden können. Die flexiblen Bereiche bestehen normalerweise aus dünnen Polyimidfolien, die ebenfalls ein- oder beidseitig kupferkaschiert sind.

Derartige starr-flexible Leiterplatten werden gewöhnlich aus übereinander liegenden starren und flexiblen Einzellagen aufgebaut, die sich über die gesamte Schaltung erstrecken und mit Hilfe eines Klebemediums miteinander verklebt und verpreßt sind (EP 0 408 773 BI). Es handelt sich hierbei um unbiegsame (z. B. glasfaserverstärktes Epoxidharz) und biegsame Isolationsträger (z. B. Polyimidfolie) mit ein- oder zweiseitigen Kupferkaschierungen, in die die Leiterbahnen geätzt werden. Die Form der starren Lagen legt den starren Teil der Leiterplatten fest. Die flexiblen Bereiche der Leiterplatten werden dadurch hergestellt, daß man in diesen Bereichen ein Teilstück der starren Lagen in mehreren Verfahrensschritten entfernt.

Als Klebemedium kann sowohl eine flüssiger bzw. fliesfähiger Kleber, der beispielsweise per Siebdruck aufgetragen wird, als auch eine Folie verwendet werden, die klebende Eigenschaften aufweist. In der Praxis werden neben reinen Klebefolien insbesondere sogenannte Prepregs verwendet. Ein Prepreg bestehen aus einem harzgetränkten Glasfasergewebe, wobei das Harz nicht vollständig polymerisiert ist. Unter Druck und Wärme verflüssigt sich das Harz und bewirkt beim anschließenden Aushärten eine Verklebung mit den angrenzenden Einzellagen Neben derartigen "normalen" Prepregs gibt es auch sogenannte no-flow Prepregs, bei denen die Fliesfähigkeit reduziert ist. Daneben werden als Klebemedium auch sogenannte Verbundfolien verwendet, die aus einer beidseitig mit Kleber versehenen flexiblen Kunststoffolie bestehen. Im Rahmen dieser Erfindung sollen sowohl Kleber als auch die zuvor beschriebenen Folien - Klebefolie, Prepregs, no-flow Prepregs und Verbundfolien - unter dem Begriff Klebemedium verstanden werden.

Aus der EP 0 408 773 B1 ist ein Verfahren zur Herstellung starr-flexibler Leiterplatten bekannt, bei dem vor dem Laminieren der Einzellagen zur Gesamtschaltung aus der starren Einzellage ein Teilstück ausgestanzt wird, das entsprechend der Größe und der gewünschten Position des flexiblen Bereichs angeordnet ist. Dieses Teilstück der starren Einzellage wird anschließend möglichst paßgenau wieder in die Einzellage eingesetzt, wobei die Verbundfolie im flexibel gewünschten Bereich der Leiterplatte eine Aussparung aufweist, so daß das zuvor ausgestanzt und wieder eingesetzte Teilstück der starren Einzellage in den nachfolgenden Verfahrensschritten nicht mit der Verbundfolie verklebt. Nach dem Laminieren muß das Teilstück während des weiteren Fertigungsprozesses hermetisch abgedeckt werden, um Metallisierungen auf dem flexiblen Bereich und dem Übergang zum starren Bereich zu verhindern. Diese Abdeckung ist aufwendig und teuer, wobei trotz großer Sorgfalt Beschädigungen auftreten können, die zu einem irreparablen Fehler führen, so daß die betroffene Leiterplatte nicht mehr verwendet werden kann.

Ein anderes Verfahren zur Herstellung starr-flexibler Leiterplatten ist aus der DE-AS 26 57 212 bekannt. Bei diesem bekannten Verfahren wird vor dem Vorpressen der Einzellagen in den starren Außenlagen auf der der flexiblen Innenlage zugewendeten Seite entlang der Trennungslinie von starrem und flexiblem Bereich der Leiterplatte eine Nut (Vornut) hergestellt, wobei die Nuttiefe so gewählt wird, daß die Außenseite der starren Lagen unverletzt bleibt. Die Verbundfolie, mit deren Hilfe die Einzellagen verklebt werden, wird über dem flexiblen Bereich der Schaltung ausgeschnitten, so daß ein Verkleben der starren Außenlage über dem zukünftigen flexiblen Bereich nicht erfolgt. Zusätzlich werden häufig Trennfolien eingelegt, die ein Fließen der Verbundfolien beim Verpressen verhindern. Nach dem Verkleben der Einzellagen und nach dem Ausbilden der Leiterbilder auf den Außenlagen wird dann zur Herstellung des flexiblen Bereichs von der Außenseite der starren Lage entlang der Trennungslinie von starrem und flexiblem Bereich der Schaltung eine weitere Nut (Hauptnut) gefräst, wobei diese Nut und die zuvor bereits ausgebildete Vornut zueinander ausgerichtet sind, so daß das ausgefräste Teilstück aus der starren Einzellage entfernt werden kann.

Unabhängig von der Art und Weise, wie das Teilstück der starren Einzellage aus dem flexibel gewünschten Bereich der Leiterplatte entfernt wird, weist die aus der EP 0 408 773 B1 bekannte starr-flexible Leiterplatte den Nachteil auf, daß ganzflächig eine relativ teure flexible Einzellage (polyimidfolie) verwendet wird, die eigentlich nur für den verhältnismäßig kleinen flexiblen Bereich benötigt wird. Dies führt dazu, daß je nach Form der Leiterplatte bis zu 75 % oder mehr der teuren Polyimidfolie "verschwendet" werden.

In der Regel werden starre-flexible Leiterplatten, die eine Fläche von einigen 10 cm² bis einigen 100 cm² aufweisen nicht einzeln hergestellt, sondern es sind eine Mehrzahl derartiger Leiterplatten nebeneinander in einer starren Platte angeordnet, die allgemein als Nutzen bezeichnet wird. Ein derartiger Nutzen weist typischerweise eine quadratische oder rechteckige Fläche mit Seitenlängen von beispielsweise 40 bis 80 cm auf. Aus einem derartigen Nutzen können dann typischerweise 20 bis 30 fertig hergestellte Leiterplatten ausgestanzt werden. Der Vorteil der Verwendung derartiger Nutzen im Vergleich zur Verwendung einzelnen Leiterplatten bei der Herstellung besteht darin, daß die Nutzen einfacher auf einem Arbeitstisch eingespannt werden können und mit einer Einspannung gleichzeitig mehrere Leiterplatten hergestellt werden können.

Da bei einem derartigen Nutzen die flexible Einzellage in der Regel ebenfalls die Abmessungen des Nutzens aufweist, wird dadurch der Anteil der "verschwendeten" teuren Polyimidfolie sogar noch erhöht, da die Polyimidfolie auch in den Zwischenbereichen zwischen den einzelnen Leiterplatten vorhanden ist, Diese Zwischenstücke werden nach dem Ausstanzen der Leiterplatten aus dem Nutzen weggeschmissen.

Aus den zuvor genannten Gründen ist bereits mehrfach vorgeschlagen worden, die relativ teure Polyimidfolie, die sich jedoch in der Praxis sehr bewährt hat, durch andere kostengünstigere flexible Einzellagen zu ersetzen, Aus der DE 41 03 375 C1 ist eine starr-flexible Leiterplatte bekannt, bei der anstelle einer separaten Verbundfolie und einer separaten Polyimidfolie nur eine Lage aus einem speziellen Fließstoff- oder Papier-Prepreg verwendet wird. Dieses Fließstoff- oder Papier-Prepreg wird direkt und vollflächig schaltungsseitig auf die gesamte starre Einzellage aufgelegt. Auf dieses spezielle Prepreg wird dann ebenfalls vollflächig eine Kupferfolie aufgebracht. Um ein Festkleben des zu entfernenden Teilstücks der starren Einzellage an dem speziellen Prepreg zu verhindern, wird eine Trennschicht auf der dem Prepreg zugewandten Seite des Teilstücks aufgebracht. Eine ähnliche starr-flexible Leiterplatte ist auch aus der DE 42 06 746 C1 bekannt, bei der ebenfalls anstelle einer teuren flexiblen Einzellage ein preisgünstigeres dünnes Prepreg verwendet wird, das auch nach dem Aushärten noch gebogen werden kann. Auch bei dieser Leiterplatte ist im flexibel gewünschten Bereich zwischen der starren Einzellage und dem Prepreg vor dem Verpressen eine Isolierfolie eingelegt.

Die DE 41 31 935 A1 beschreibt eine starr-flexible Leiterplatte, die ausschließlich aus einem an sich starren Leiterplattenmaterial besteht, so daß gänzlich auf eine teure Polyimidfolie verzichtet worden ist. Bei dieser bekannten Leiterplatte, die jedoch nur eine begrenzte Anzahl von Biegbeanspruchungen aushält, weist das starre Leiterplattenmateria im flexibel gewünschten Bereich eine deutlich geringere Dicke auf. Diese Leiterplatte, die zwar relativ einfach und kostengünstig hergestellt werden kann, ist in ihrem Einsatzbereich zum einen durch die nur begrenzte Flexibilität eingeschränkt, zum anderen nicht für komplexere Schaltungen mit mehreren Leiterbahnenebenen geeignet.

Auch aus der DE 40 03 345 C1 ist eine starr-flexible Leiterplatte bekannt, die im wesentlichen nur im flexibel gewünschten Bereich eine flexible Polyimidfolie aufweist. Dabei ist die Polyimidfolie auf der der Kupferfolie zugewandten Seite mit einer flexiblen Klebeschicht und auf der der starren Einzellage zugewandten Seite mit zwei am Rand angeordneten dünnen Klebestreifen versehen. Die Breite und die Lage der dünnen Klebestreifen muß dabei so gewählt werden, daß ein Festkleben des zu entfernenden Teilstücks der starren Einzellage an den Klebestreifen verhindert wird. Da die dünnen Klebestreifen häufig nur eine Breite von 1 mm oder weniger aufweisen ist die Vorfertigung der Polyimidfolie mit den Klebestreifen auf der einen Seite und der Klebeschicht auf der anderen Seite relativ zeitaufwendig. Darüber hinaus ist es auch erforderlich, daß die so präparierte Polyimidfolie sehr genau auf der starren Einzellage positioniert wird, da es sonst ebenfalls zu einem Festkleben des zu entfernenden Teilstückes der starren Einzellage kommen kann.

Die DE 42 08 610 C1 beschreibt ein Verfahren zur Herstellung starr-flexibler Leiterplatten, bei dem zunächst in die starre Außenlage Sollbruchstellen entlang der starr-flexiblen Übergänge hergestellt und zwischen den starren Außenlagen ein flexibles Teilstück eingelegt wird. Das mit einer Deckfolie versehene flexible Teilstück ist dabei in einem getrennten Arbeitsschritt als ein- oder mehrlagige flexible Leiterplatte vorgefertigt. Zur späteren Verbindung mit den Leiterbahnen der starren Bereiche besitzt die flexible Leiterplatte Verbindungsleitungen.

Aus der DE 33 02 857 A1 ist eine eingangs beschriebene Leiterplatte bekannt, die im starren Bereich keine flexible Einzellage aufweist. Gemäß einem bevorzugten Ausführungsbeispiel weist die bekannte Leiterplatte eine starre Einzellage auf, auf der mittels eines vollflächigen Klebers eine Metallfolie aufgebracht ist. In dem später flexiblen Bereich der Leiterplatte ist zum einen die Metallfolie mit einer Kunststoffolie abschnittsweise beschichtet, sind zum anderen in dem später flexiblen Bereich auf der starren Einzellage Klebestreifen aufgebracht. Durch die Klebestreifen wird beim Herstellen der starr-flexiblen Leiterplatte, d. h. beim Entfernen der Teilbereiche der starren Einzellage aus dem flexiblen Bereich der Leiterplatte, ein unerwünschtes Anhaften der Teilbereiche an dem Kleber verhindert.

Der vorliegenden Erfindung liegt somit die Aufgabe zugrunde, eine eingangs beschriebene starr-flexible Leiterplatte zur Verfügung zu stellen bzw. einer Multilayer-Leiterplatte bestehend aus mindestens einer solchen Leiterplatte, bzw. ein Verfahren zur Herstellung einer solchen starr-flexiblen Leiterplatte anzugeben, bei der zum einen auf die Verwendung teurer flexibler Einzellagen verzichtet wird, die zum anderen jedoch möglichst einfach, schnell und damit kostengünstig hergestellt werden kann.

Die zuvor genannte Aufgabe ist bei der eingangs beschriebenen Leiterplatte gemäß dem Oberbegriff von Anspruch 1 dadurch gelöst, daß das Klebemedium im flexiblen Bereich Aussparungen aufweist, daß vollständig auf eine flexible Einzellage als Träger für die Kupferfolie verzichtet wird, daß die Kupferfolie direkt mit dem Klebemedium auf der starren Einzellage befestigt ist und daß die Isolationsschicht ein auf die Kupferfolie aufgebrachter Kunststofflack ist.

Bei der erfindungsgemäßen Leiterplatte ist somit auch im später flexiblen Bereich keine flexible Einzellage, insbesondere keine Polyimidfolie, zwischen der starren Einzellage und der Kupferfolie vorgesehen. Polyimidfolien haben den Nachteil, daß sie Feuchtigkeit aufnehmen, so daß beim Herstellen der Leiterplatten sowie beim Bestücken der Leiterplatten häufig mehrere, zeitaufwendige Trocknungsvörgänge notwendig sind, um eine Beschädigung der Leiterplatte durch Delaminieren der verklebten Bereiche oder Abplatzen von Leiterbahnen in einem späteren Arbeitsschritt zu verhindern. Wird vollständig auf eine Polyimidfolie verzichtet, so können dann die ansonsten notwendigen Trocknungsvorgänge entfallen.

Befindet sich im starren Bereich der Leiterplatte keine Polyimidfolie, so hat dies darüber hinaus den Vorteil, daß auf eine Sonderbehandlung, beispielsweise mittels Plasmareinigung, der Bohrungen in der Leiterplatte, die zum Verbinden der einzelnen Ebenen einer mehrlagigen Leiterplatte metallisiert werden, verzichtet werden kann.

Bei der erfindungsgemäßen Leiterplatte ist im flexiblen Bereich auf der Innenseite der Kupferfolie eine Isolationsschicht unmittelbar auf der Kupferfolie aufgebracht, wobei die Isolationsschicht ein auf die Kupferfolie aufgebrachter Lack ist. Die Isolationsschicht muß zum einen die Isolation der Kupferfolie nach außen bzw. von einzelnen Leiterbahnen untereinander gewährleisten, zum anderen eine ausreichende Biegbarkeit aufweisen, so daß die Flexibilität des flexiblen Bereichs der Leiterplatte durch die Isolationsfolie nicht wesentlich beeinträchtigt wird. Schließlich muß die Isolationsfolie noch so beschaffen sein, daß sie unmittelbar auf der Kupferfolie haftet. Besonders einfach kann die Isolationsschicht dabei durch einen flexiblen Lack, insbesondere einen Lötstopplack, realisiert sein. Derartige Lacke sind sehr kostengünstig, nehmen so gut wie keine Feuchtigkeit auf, so daß die Trocknungsvorgänge entfallen können, und lassen sich darüber hinaus mit einer Vielzahl von bekannten Verfahren sehr schnell und einfach an der gewünschten Position auf die Kupferfolie auftragen.

Gemäß einer vorteilhaften Ausgestaltung der erfindungsgemäßen Leiterplatte ist zumindest im flexiblen Bereich eine weitere Isolationsschicht auf der Außenseite der Kupferfolie aufgebracht. Ebenso kann die Isolationsschicht auch auf der gesamten Außenfläche der Kupferschicht aufgetragen werden. Hierbei kann als Isolationsschicht wiederum beispielsweise ein flexibler Lötstopplack verwendet werden. Durch diese zweite Isolationsschicht auf der Außenseite der Kupferfolie wird das in der Kupferfolie durch Ätzen hergestellte Leiterbild geschützt und insbesondere im flexiblen Bereich mechanisch stabilisiert. Anstelle eines Lötstopplackes kann hier auch eine andere bekannte Deckfolie verwendet werden.

Die erfindungsgemäße Leiterplatte eignet sich nicht nur zur Herstellung von zweilagigen starr-flexiblen Leiterplatten, sondern auch zur Herstellung von sogenannten Multilayer-Leiterplatten, die eine Vielzahl von Lagen mit zumeist einem Leiterbilder in jeder Lage aufweisen, Daher betrifft die Erfindung auch eine Multilayer-Leiterplatte mit mindestens einem starren Bereich und mindestens einem flexiblen Bereich, bestehend aus mindestens einer zuvor beschriebenen erfindungsgemäßen Leiterplatte, wobei mehrere ein- oder beidseitig kupferkaschierte oder mit Leiterbahnen versehene starre Einzellagen und/oder mehrere im flexiblen Bereich mit einer Isolationsschicht versehene Kupferfolien vorgesehen sind und wobei die starren Einzellagen untereinander und/oder die Kupferfolien untereinander und/oder die starren Einzellagen und die Kupferfolien miteinander mittels eines Klebemediums miteinander verklebt sind.

Bei dem eingangs beschriebenen Verfahren gemäß dem Anspruch 6 zur Herstellung von starrflexiblen Leiterplatten gemäß dem Anspruch 1 ist die zuvor genannte Aufgabe erfindungsgemäß dadurch gelöst, daß zunächst auf einer Seite der Kupferfolie im flexiblen Bereich eine nicht ausgehärtete Isolationsschicht aufgebracht wird, daß die Isolationsschicht so weit ausgehärtet wird, daß die freie Oberfläche ihre Klebefähigkeit verliert, daß danach die so vorbehandelte Kupferfolie mittels des Klebemediums mit der starren Einzellage verklebt wird, wobei die Seite der Kupferfolie mit der Isolationsschicht der starren Einzellage zugewandt ist, und daß anschließend im flexiblen Bereich der Leiterplatte ein Teilstück der starren Einzellage entfernt wird, Dadurch, daß die Isolationsschicht nach dem Auftragen auf die Kupferfolie teilgehärtet wird, wodurch die freie Oberfläche der Isolationsschicht ihre Klebefähigkeit verliert, ist sichergestellt, daß das zu entfernende Teilstück der starren Einzellage nicht an der Isolationsschicht anhaftet, wodurch das anschließende Entfernen des Teilstücks erschwert oder ganz verhindert würde.

Bei diesem Verfahren weist die fertige Leiterplatte im flexiblen Bereich lediglich die Kupferfolie auf, die innenseitig von einer Isolationsschicht abgedeckt ist. Dabei wird zunächst die Isolationsschicht vor dem Verkleben und Verpressen der Leiterplatte auf der Kupferfolie aufgebracht. Gemäß einem alternativen Verfahren das nicht zur Erfindung gehört, kann zunächst die Leiterplatte verklebt und verpreßt werden, sodann im flexiblen Bereich ein Teilstück der starren Leiterplatte entfernt und erst dann der nun zugängliche Bereich der Kupferfolie mit der Isolationsschicht versehen werden.

Gemäß einer vorteilhaften Ausgestaltung des erfindungsgemäßen Verfahrens wird die Isolationsschicht, bei der es sich beispielsweise um einen flexiblen Lötstopplack handeln kann, auf die Kupferfolie gesprüht, gerollt oder gedruckt. All diese Techniken zum Aufbringen der Isolationsschicht auf die Kupferfolie sind einfach und kostengünstig durchzuführen, wobei durch Verwendung entsprechender Schablonen die Isolationsschicht genau an einer vorgegebenen Position auf die Kupferfolie aufgebracht werden kann. Darüber hinaus können mit diesen Methoden gleichzeitig eine Mehrzahl von Isolationsschichten auf eine großflächige Kupferfolie aufgebracht werden, so daß in einem Verfahrensschritt die Kupferfolie für einen kompletten Nutzen, d. h. für eine Mehrzahl von Leiterplatten, präpariert werden kann.

Im einzelnen gibt es nun eine Vielzahl von Möglichkeiten, die erfindungsgemäße Leiterplatte bzw. das erfindungemäße Verfahren auszugestalten und weiterzubilden. Hierzu wird verweisen einerseits auf die den Patentansprüchen 1, 7 und 8 nachgeordneten Patentansprüche, andererseits auf die nachfolgende Beschreibung eines bevorzugten Ausführungsbeispieles in Verbindung mit der Zeichnung. In der Zeichnung zeigen
- Fig. 1: eine schematische Schnittdarstellung einer aus dem Stand der Technik bekannten starr-flexiblen Leiterplatte und
- Fig. 2: eine schematische Schnittdarstellung eines Ausführungsbeispiels einer erfindungsgemäßen starr-flexiblen Leiterplatte.

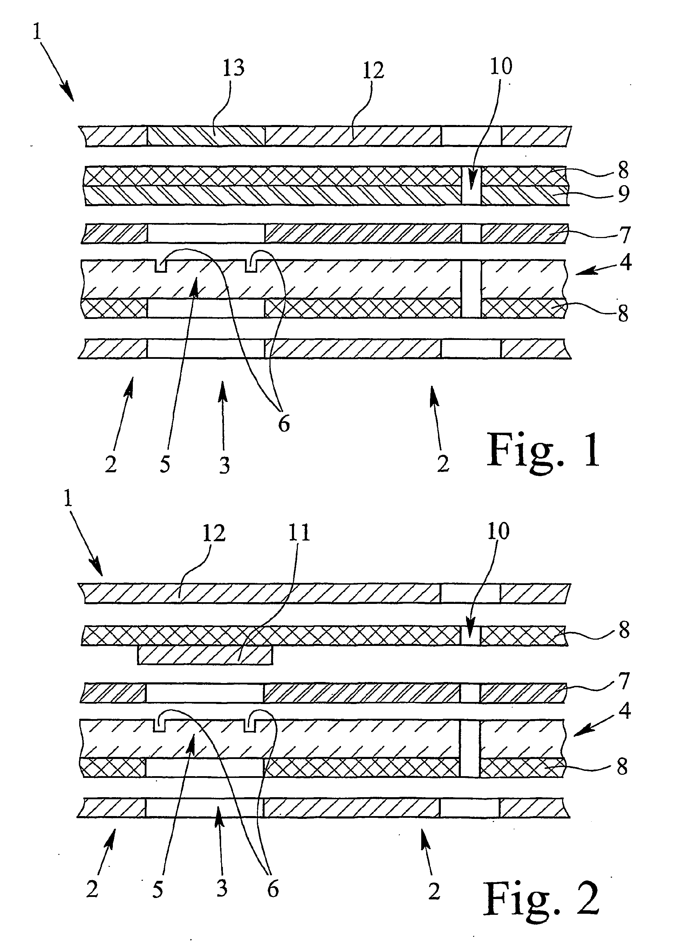

Die Fig. 1 und 2 zeigen eine Schnittdarstellung durch eine bekannte Leiterplatte 1 (Fig. 1) und durch eine erfindungsgemäße Leiterplatte 1 (Fig. 2). Die in den Figuren nur schematisch und noch nicht verklebt und verpreßt dargestellte Leiterplatte 1 soll im fertig montierten Zustand zwei starre Bereiche 2 und einen, die beiden starren Bereiche 2 miteinander verbindenden, flexiblen Bereich 3 aufweisen. Zur Erzielung dieses flexiblen Bereichs 3 wird nach dem Verpressen der Leiterplatte 1 aus der starren Einzellage 4 ein Teilstück 5 herausgefräst. Hierzu sind in der starren Einzellage 4 auf der Innenseite bereits zwei Vornuten 6 ausgebildet.

Neben der starren Einzellage 4, die im dargestellten Ausführungsbeispiel einseitig kupferkaschiert ist, weist sowohl die bekannte Leiterplatte 1 als auch die erfindungsgemäße Leiterplatte 1 ein Klebemedium 7 und eine Kupferfolie 8 auf. Das Klebemedium 7, das zumeist von einem Prepreg gebildet wird, weist im flexiblen Bereich 3 eine Aussparung auf, so daß es nicht zu einem Verkleben des Teilstücks 5 mit dem Klebemedium 7 kommt.

Bei der bekannten Leiterplatte 1 gemäß Fig. 1 ist darüber hinaus noch eine flexible Einzellage 9 vorgesehen, die als Träger für die Kupferfolie 8 dient und mittels des Klebemediums 7 mit der starren Einzellage 4 verklebt und verpreßt wird. Diese flexible Einzellage 9 besteht zumeist aus einer relativ teuren Polyimidfolie, die sich einerseits zwar als Träger der Kupferfolie 8 bei Millionen von starr-flexiblen Leiterplatten 1 bewährt hat, die andererseits jedoch zusätzlich zu dem im Vergleich zur starren Einzellage 4 hohen Preis noch weitere Nachteile aufweist. Aufgrund der Tatsache, daß die Polyimidfolie Feuchtigkeit aufnimmt, sind sowohl beim Herstellen der Leiterplatte 1 als auch beim späteren Bestücken häufig mehrere Trocknungsvorgänge erforderlich, um Schäden an der Leiterplatte 1, insbesondere an den Leiterbildern, durch das Verdampfen der aufgenommenen Flüssigkeit zu verhindern. Darüber hinaus verursacht die Verwendung einer Polyimidfolie als flexible Einzellage 9 auch im starren Bereich 2 der Leiterplatte 1 einen erhöhten Aufwand bei der Reinigung der in die Leiterplatte 1 eingebrachten Bohrungen 10. Die Bohrungen 10 dienen dazu, die einzelnen Leiterbilder in den verschiedenen Ebenen der Leiterplatte 1 miteinander zu verbinden. Aus diesem Grunde werden die Bohrungen 10 metallisiert, wofür jedoch vorher eine besondere Reinigung der Bohrungen 10 erforderlich ist, die beim Durchbohren einer Polyimidfolie zumeist einer Sonderbehandlung in Form einer Plasmareinigung erfordert.

Bei der in Fig. 2 dargestellten erfindungsgemäßen Leiterplatte ist dagegen auf eine flexible Einzellage 9, insbesondere eine Polyimidfolie, ganz verzichtet worden. Die Kupferfolie 8 wird direkt mittels des Klebemediums 7 auf der starren Einzellage 4 befestigt. Zur Verhinderung von unzulässigen elektrischen Kontakten der Kupferfolie 8 mit anderen Bauteilen oder von Kurzschlüssen zwischen einzelnen auf der Kupferfolie 8 ausgebildeten Leiterbahnen ist auf der Innenseite, d. h. auf der der starren Einzellage 4 zugewandten Seite, der Kupferfolie 8 eine dünne Isolationsschicht 11 aufgebracht. Zur Sicherstellung einer ausreichenden Isolation überragt die Isolationsschicht 11 geringfügig die Fläche des herauszufräsenden Teilstücks 5 der starren Einzellage 4.

Bei einer bevorzugten Ausgestaltung der erfindungsgemäßen Leiterplatte 1 bzw. des erfindungsgemäßen Verfahrens zur Herstellung einer starr-flexiblen Leiterplatte 1 wird die Isolationsschicht 11 vor dem Verkleben und Verpressen der Leiterplatte 1 auf die Kupferfolie 8 aufgebracht. Hierzu kann beispielsweise besonders einfach ein flexibler Kunststofflack, insbesondere ein flexibler Lötstopplack, auf die entsprechende Stelle auf der Kupferfolie 8 aufgesprüht oder aufgedruckt werden. Mit Hilfe derartigen Methoden wie Sprühen, Drucken oder Rollen läßt sich die Isolationsschicht 11 sehr einfach, schnell und positionsgenau auf die gewünschten Stellen einer Kupferfolie 8 auftragen. Dabei können gleichzeitig eine Vielzahl von Isolationsschichten 11 auf eine Kupferfolie 8 einer entsprechenden Größe aufgebracht werden, so daß in einem Verfahrensschritt eine Kupferfolie 8 für mehrere Leitplatten 1 vorbereitet werden kann.

Gemäß einem alternativen - hier jedoch nicht dargestellten - Verfahren zur Herstellung einer erfindungsgemäßen starr-flexiblen Leiterplatte 1 ist es auch möglich, die Isolationsschicht 11 erst nach dem Verkleben und Verpressen der Leiterplatte 1 auf die Innenseite der Kupferfolie 8 aufzutragen. Bei diesem Verfahren wird dann vor dem Auftragen der Isolationsschicht 11 zunächst das Teilstück 5 aus der starren Einzellage 4 entfernt, so daß die Innenseite der Kupferfolie 8 im flexiblen Bereich 3 der Leiterplatte 1 zugänglich wird. Grundsätzlich ist es daneben auch möglich, auf die Verwendung einer Isolationsschicht 11 gänzlich zu verzichten, wenn die Gefahr von unerlaubten elektrischen Kontakten oder Kurzschlüssen auf andere Art und Weise, beispielsweise durch ein Vergießen einer in ein Gehäuse eingesetzten Leiterplatte 1, ausgeschlossen wird.

Die erfindungsgemäße Leiterplatte 1 weist darüber hinaus noch eine weitere Isolationsschicht 12 auf, die nach dem Verkleben und Verpressen der Kupferfolie 8 mit der starren Einzellage 4 auf die Außenseite der dann bereits strukturierten Kupferfolie 8 aufgebracht wird. Bei der erfindungsgemäßen Leiterplatte 1 gemäß Fig. 2 weist auch diese Isolationsschicht 12 - im Unterschied zur bekannten Leiterplatte 1 gemäß Fig. 1 - keine Polyimidfolie als partielle Deckfolie 13 auf. Die Isolationsschicht 12 kann wiederum aus einem flexiblen Lötstopplack gebildet werden, der entweder nur partiell im flexiblen Bereich 3 der Leiterplatte 1 oder - mit Ausnahme der Bohrungen 10 - ganzflächig auf die Kupferfolie 8 aufgesprüht wird.

Die in Fig. 2 dargestellte erfindungsgemäße Leiterplatte 1 zeichnet sich somit durch eine besonders einfache, schnelle und kostengünstige Herstellung aus. Zunächst erfolgt bereits eine Kosteneinsparung dadurch, daß auf eine relativ teure Polyimidfolie gänzlich verzichtet wird. Darüber hinaus ist das Auftragen der beispielsweise aus Lötstopplack bestehenden Isolationsschichten 11 und 12 im Sprüh- oder Druckverfahren sehr einfach, präzise und schnell möglich.

Aufgrund des unterschiedlichen Ausdehnungskoeffizienten der starren Einzellage 4 und der im Stand der Technik verwendeten Polyimidfolie kommt es bei den im Stand der Technik verwendeten Leiterplatten 1 bei auftretenden Temperaturschwankungen häufig zu einer unerwünschten Durchbiegung der Leiterplatte 1 sowie zu einer unterschiedlichen Dickenausdehnung der Leiterplatte 1 zwischen den starren Bereichen 2 und dem flexiblen Bereich 3, was zu Rissen in den Leiterbahnen oder in den metallisierten Bohrungen 10 führen kann. Bei der erfindungsgemäßen Leiterplatte kann dagegen das Material der Isolationsschicht 11, 12 so gewählt werden, daß die Leiterplatte 1 im wesentlichen aus Materialien mit ähnlichem Ausdehnungskoeffizienten besteht. Daraus ergibt sich als weiterer Vorteil ein homogeneres Ausdehnungsverhalten der Leiterplatte 1, so daß die Leiterplatte 1 bei Wärmeeinwirkung nur minimale, zulässige Verwindungen und Wölbungen aufweist. Dadurch ist die erfindungsgemäße Leiterplatte 1 beispielsweise im Automotivbereich, in dem häufig große Temperaturschwankungen auftreten, besonders gut einsetzbar.

## Patentansprüche

1. Leiterplatte mit mindestens einem starren Bereich (2) und mindestens einem flexiblen Bereich (3), mit einer ein- oder beidseitig kupferkaschierten oder mit Leiterbahnen versehenen starren Einzellage (4), mit einem Klebemedium (7) und mit mindestens einer Kupferfolie (8),
wobei im starren Bereich (2) keine flexible Einzellage (9) zwischen dem Klebemedium (7) und der Kupferfolie (8) vorgesehen ist, und
wobei im flexiblen Bereich (3) auf der dem Klebemedium (7) bzw. der starren Einzellage (4) zugewandten Seite der Kupferfolie (8) eine Isolationsschicht (11) unmittelbar auf der Kupferfolie (8) aufgebracht ist,
**dadurch gekennzeichnet,**
**daß** das Klebemedium (7) im flexiblen Bereich (3) Aussparungen aufweist,
**daß** vollständig auf eine flexible Einzellage (9) als Träger für die Kupferfolie (8) verzichtet wird,
**daß** die Kupferfolie (8) direkt mit dem Klebemedium (7) auf der starren Einzellage (4) befestigt ist, und
**daß** die Isolationsschicht (11) ein auf die Kupferfolie (8) aufgebrachter Lack ist.

2. Leiterplatte nach Anspruch 1, **dadurch gekennzeichnet, daß** die Isolationsschicht (11) ein auf die Kupferfolie (8) aufgebrachter flexibler Lötstopplack ist.

3. Leiterplatte nach Anspruch 1 oder 2, **dadurch gekennzeichnet, daß** zumindest im flexiblen Bereich (3) eine weitere Isolationsschicht (12) auf der Außenseite der Kupferfolie (8) aufgebracht ist.

4. Leiterplatte nach Anspruch 3, **dadurch gekennzeichnet, daß** die weitere Isolationsschicht (12) ein auf die Kupferfolie (8) aufgebrachter Lack, insbesondere ein flexibler Lötstopplack ist.

5. Multilayer-Leiterplatte mit mindestens einem starren Bereich und mindestens einem flexiblen Bereich bestehend aus mindestens einer Leiterplatte nach einem der Ansprüche 1 bis 4, **dadurch gekennzeichnet, daß** mehrere ein- oder beidseitig kupferkaschierten oder mit Leiterbahnen versehenen starre Einzellagen und/oder mehrere im flexiblen Bereich mit einer Isolationsschicht versehene Kupferfolien vorgesehen sind, und daß die starren Einzellangen untereinander und/oder die Kupferfolien untereinander und/oder die starren Einzellagen und die Kupferfolien miteinander mittels Klebemedien miteinander verklebt sind.

6. Verfahren zur Herstellung von starr-flexiblen Leiterplatten (1) nach Anspruch 1, mit mindestens einer ein- oder beidseitig kupferkaschierten oder mit Leiterbahnen versehenen starren Einzellage (4), mit einem Klebemedium (7) und mit mindestens einer Kupferfolie (8), wobei das Klebemedium (7) in einem flexiblen Bereich (3) Aussparungen aufweist,
**dadurch gekennzeichnet,**
**daß** zunächst auf einer Seite der Kupferfolie (8) im flexiblen Bereich (3) eine nicht ausgehärtete Isolationsschicht (11) aufgebracht wird,
**daß** die Isolationsschicht (11) so weit ausgehärtet wird, daß die freie Oberfläche ihre Klebefähigkeit verliert,
**daß** die so vorbehandelte Kupferfolie (8) Mittels des Klebemediums (7) mit der starren Einzellage (4) verklebt wird und
**daß** anschließend im flexiblen Bereich (3) der Leiterplatte (1) ein Teilstück (5) aus der starren Einzellage (4) entfernt wird.

7. Verfahren nach Anspruch 6, **dadurch gekennzeichnet, daß** zumindest im flexiblen Bereich der Leiterplatte eine weitere Isolationsschicht auf der Außenseite der Kupferfolie aufgebracht wird.

8. Verfahren nach Anspruch 6 oder 7, **dadurch gekennzeichnet, daß** die Isolationsschicht bzw. die Isolationsschichten auf die Kupferfolie gesprüht, gerollt oder gedruckt wird bzw. werden.

## Claims

1. Circuit board with at least one rigid area (2) and at least one flexible area (3) with a rigid individual layer (4) which is provided with printed conductors or is copper-clad on one or both sides, with an adhesive medium (7) and with at least one copper foil (8),
wherein in the rigid area (2) there is no flexible individual layer (9) between the adhesive medium (7) and the copper foil (8) and
wherein an insulating layer (11) is applied directly to the copper foil (8) in the flexible area (3) on the side of the copper foil (8) facing the adhesive medium (7) or the rigid individual layer (4)
**characterized in**
**that** the adhesive medium (7) has recesses in the flexible area (3),
**that** there is no flexible individual layer (9) as carrier for the copper foil (8),
**that** the copper foil (8) is directly attached to the rigid individual layer (4) with the adhesive medium (7), and
**that** the insulating layer (11) is a resist applied to the copper foil (8).

2. Circuit board according to claim 1, **characterized in that** the insulating layer (11) is a flexible older resist that has been applied to the copper foil (8).

3. Circuit board according to claim 1 or 2, **characterized in that** at least in the flexible area (3) another insulating layer (12) is applied to the outer side of the copper foil (8).

4. Circuit board according to claim 3, **characterized in that** the other insulating layer (12) is a resist, especially a flexible solder resist that has been applied to the copper foil (8).

5. Multi-layer circuit board with at least one rigid area and at least one flexible area, comprising at least one circuit board according to any one of claims 1 to 4, **characterized in that** there are several rigid individual layers which are provided with printed conductors or which are copper-clad on one or both sides, and/or several copper foils which are provided with an insulating layer in the flexible area, and that the rigid individual layers are cemented among one another and/or the copper foils are cemented among one another and/or the rigid individual layers and the copper foils are cemented to one another by means of adhesive media.

6. Process for producing rigid-flexible circuit boards (1) according to claim 1 with at least one rigid individual layer (4) which is provided with printed conductors or is copper-clad on one or both sides, with an adhesive medium (7) and with at least one copper foil (8), wherein the adhesive medium (7) has recesses in the flexible area (3) **characterized in**
**that** first an uncured insulating layer (11) is applied to one side of the copper foil (8) in the flexible area (3),
**that** the insulating layer (11) is cured to such an extent that the free surface loses its adhesive capacity,
**that** the copper foil (8) which has been pretreated in this way is cemented by means of the adhesive medium (7) to the rigid individual layer (4) and
**that** then in the flexible area (3) of the circuit board (1) a piece (5) is removed from the rigid individual layer (4).

7. Process according to claim 6, **characterized in that** at least in the flexible area of the circuit board another insulating layer is applied to the outer side of the copper foil.

8. Process according to claim 6 or 7, **characterized in that** the insulating layer or insulating layers is or are sprayed, rolled or printed onto the copper foil.

## Revendications

1. Carte de circuit imprimé qui présente au moins une partie rigide (2) et au moins une partie flexible (3), une couche simple rigide (4) recouverte de cuivre ou dotée de pistes conductrices sur une ou deux faces, un adhésif (7) et au moins une feuille de cuivre (8), aucune couche simple flexible (9) n'étant prévue dans la partie rigide (2) entre l'adhésif (7) et la feuille de cuivre (8), une couche isolante (11) étant appliquée directement sur la feuille de cuivre (8) dans la partie flexible (3), sur le côté de la feuille de cuivre (8) tourné vers l'adhésif (7) ou la couche simple rigide (4),
**caractérisée en ce**
**que** l'adhésif (7) présente des découpes dans la partie flexible (3),
en ce qu'aucune couche simple flexible (9) n'est prévue comme support pour la feuille de cuivre (8),
en ce que la feuille de cuivre (8) est fixée directement par l'adhésif (7) sur la couche simple rigide (4) et
en ce que la couche isolante (11) est un vernis appliqué sur la feuille de cuivre (8).

2. Carte de circuit imprimé selon la revendication 1, **caractérisée en ce que** la couche isolante (11) est un vernis flexible de blocage de brasure appliqué sur la feuille de cuivre (8).

3. Carte de circuit imprimé selon les revendications 1 ou 2, **caractérisée en ce qu'**au moins dans la partie flexible (3), une autre couche isolante (12) est appliquée sur le côté extérieur de la feuille de cuivre (8).

4. Carte de circuit imprimé selon la revendication 3, **caractérisée en ce que** l'autre couche isolante (12) est un vernis appliqué sur la feuille de cuivre (8), en particulier un vernis flexible de blocage de brasure.

5. Carte de circuit imprimé multicouche qui présente au moins une partie rigide et au moins une partie flexible, constituée d'au moins une carte de circuit imprimé selon l'une des revendications 1 à 4,
**caractérisée en ce**
**que** plusieurs couches simples rigides revêtues de cuivre ou dotées de pistes conductrices sur une ou deux faces et/ou plusieurs feuilles de cuivre dotées d'une couche isolante dans la partie flexible sont prévues et
en ce que les couches simples rigides sont collées les unes sur les autres et/ou les feuilles de cuivre sont collées les unes sur les autres et/ou les couches simples rigides et les feuilles de cuivre sont collées les unes sur les autres au moyen d'adhésifs.

6. Procédé de fabrication de cartes rigides-flexibles de circuit imprimé (1) selon la revendication 1, qui présentent au moins une couche simple rigide (4) revêtue de cuivre ou dotée de pistes conductrices sur une ou deux faces, un adhésif (7) et au moins une feuille de cuivre (8), l'adhésif (7) présentant des découpes dans la partie flexible (3),
**caractérisé en ce**
**que** une couche isolante (11) non durcie est d'abord appliquée sur une face de la feuille de cuivre (8) dans la partie flexible (3),
en ce que la couche isolante (11) est durcie suffisamment pour que sa surface libre perde son pouvoir adhésif,
en ce que la feuille de cuivre (8) ainsi pré-traitée est collée sur la couche simple rigide (4) au moyen de l'adhésif (7) et
en ce qu'une partie (5) de la couche simple rigide (4) est ensuite enlevée dans la partie flexible (3) de la carte de circuit imprimé (1).

7. Procédé selon la revendication 6, **caractérisé en ce qu'**au moins dans la partie flexible de la carte de circuits imprimés, une autre couche isolante est appliquée sur le côté extérieur de la feuille de cuivre.

8. Procédé selon les revendications 6 ou 7, **caractérisé en ce que** la couche isolante ou les couches isolantes sont pulvérisées, stratifiées ou imprimées sur la feuille de cuivre.
